# EUROPEAN PATENT SPECIFICATION

(11) **EP 3 552 245 B1**
(45) Date of publication and mention of the grant of the patent: **08.09.2021**
(21) Application number: 18897868.8
(22) Date of filing: 18.01.2018
(51) Int. Cl.: H01L 31/18

(54) **METHOD OF MANUFACTURING SHINGLED SOLAR MODULES**
VERFAHREN ZUR HERSTELLUNG VON SCHINDELSOLARMODULEN
PROCÉDÉ DE FABRICATION DE MODULES SOLAIRES EN BARDEAUX

(43) Date of publication of application: 16.10.2019
(73) Proprietor: Flex Ltd., 486123 Singapore (SG)
(72) Inventor: ZHOU, Lisong, Freemont, CA 94539 (US); ZHOU, Huaming, Wuxi Jiangsu 214000 (CN)
(74) Representative: v. Bezold & Partner Patentanwälte - PartG mbB
(86) International application number: PCT/CN2018/073256
(87) International publication number: WO 2019/140606

(56) References cited:
- WO-A1-2016/090332
- CN-A- 101 969 086
- CN-A- 104 205 347
- CN-A- 104 919 597
- CN-A- 105 122 463
- CN-A- 106 298 987
- CN-A- 106 653 947
- CN-A- 106 997 906
- US-A1- 2017 077 343
- US-A1- 2017 125 619
- US-B1- 7 122 398
- N KLASEN ET AL: "Shingled Cell Interconnection: Aiming for a New Generation of Bifacial PV-Modules", FRAUNHOFER ISE, 24 October 2017 (2017-10-24), pages 1-36, XP055637471,
- N Wöhrle ET AL: "The SPEER Solar Cell - Simulation Study of Shingled Bifacial PERC-Technology-Based Stripe Cells", 33rd European Photovoltaic Solar Energy Conference and Exhibition, proceedings of the International Conference, 25 September 2017 (2017-09-25), pages 1-5, XP055698113, Sylvensteinstr. 2 81369 Munich, Germany DOI: 10.4229/EUPVSEC20172017-2CV.2.33 ISBN: 978-3-936338-47-8 Retrieved from the Internet: URL:https://www.ise.fraunhofer.de/content/ dam/ise/de/documents/publications/conferen ce-paper/33-eupvsec-2017/Woehrle_2CV233.pd f

## Description

### Technical Field

The present disclosure relates to solar modules, and more particularly, to solar modules formed of shingled cells or strips of cells, which deliver a higher module efficiency than conventional ribbon interconnected solar modules.

### Background

Over the past few years, the use of fossil fuels as an energy source has been trending downward. Many factors have contributed to this trend. For example, it has long been recognized that the use of fossil fuel-based energy options, such as oil, coal, and natural gas, produces gases and pollution that may not be easily removed from the atmosphere. Additionally, as more fossil fuel-based energy is consumed, more pollution is discharged into the atmosphere causing harmful effects on life close by. Despite these effects, fossil-fuel based energy options are still being depleted at a rapid pace and, as a result, the costs of some of these fossil fuel resources, such as oil, have risen. Further, as many of the fossil fuel reserves are located in politically unstable areas, the supply and costs of fossil fuels have been unpredictable.

Due in part to the many challenges presented by these traditional energy sources, the demand for alternative, clean energy sources has increased dramatically. To further encourage solar energy and other clean energy usage, some governments have provided incentives, in the form of monetary rebates or tax relief, to consumers willing to switch from traditional energy sources to clean energy sources.

In other instances, consumers have found that the long-term savings benefits of changing to clean energy sources have outweighed the relatively high upfront cost of implementing clean energy sources.

One form of clean energy, solar energy, has risen in popularity over the past few years. Advancements in semiconductor technology have allowed the designs of solar modules and solar panels to be more efficient and capable of greater output. Further, the materials for manufacturing solar modules and solar panels have become relatively inexpensive, which has contributed to the decrease in costs of solar energy. As solar energy has increasingly become an affordable clean energy option for individual consumers, solar module and panel manufacturers have made available products with aesthetic and utilitarian appeal for implementation on residential structures. As a result of these benefits, solar energy has gained widespread global popularity.

The presentation of N. Klasen et al., "Shingled Cell Interconnection: Aiming for New Generation of Bifacial PV-Modules", provides an overview of the shingled cell interconnection technology. Furthermore, two calculation approaches for the joint deformation due to thermal expansion of the module materials are compared and the most relevant parameters are identified. The results show that the thickness of the joint material is crucial to reduce the shear deformation. Other geometrical parameters like the overlap width or number of solar cells per string only show a small effect on shear strain. Additionally, first experimental prototypes of shingled mini-modules of bifacial "p-type shingled passivated edge, emitter, and rear", pSPEER, solar cells using low temperature soldering are presented.

Document US 7 122 398 B1 discloses a method for manufacturing optoelectronic devices. A layered structure is formed with a plurality of layers including a bottom electrode layer, a top electrode layer, and one or more active layers between the top and bottom electrode layers. The layered structure is divided into one or more separate device module sections by cutting through one or more of the layers of the layered structure. Each of the resulting device module sections generally includes a portion of the active layer disposed between portions of the top and bottom electrode layers. An edge of a device section is protected against undesired electrical contact between two or more of the bottom electrode, top electrode and active layer portions. Two or more device module sections may be assembled into a device and connected in series by electrically connecting the bottom electrode layer portion of one device section to the top electrode layer portion of another device module section.

### Summary

Further details and aspects of exemplary embodiments of the present disclosure are described in more detail below with reference to the appended figures.

The present disclosure is directed to a method including singulating a solar cell to form a plurality of strips, wherein the singulation exposes unpassivated portions of the solar cell, sorting the strips which includes placing the singulated strips in a stack with the unpassivated portions aligned, covering at least top and bottom surfaces of the stack or covering all passivated surfaces of the strips placed in the stack leaving only the unpassivated portions exposed, and re-passivating the unpassivated portions of the plurality of strips placed in the stack, wherein the re-passivation eliminates active recombination centers. The method further includes aligning the re-passivated strips in an overlapping pattern, depositing electrically conductive adhesive (ECA) between the overlapped portions of the re-passivated strips, wherein the ECA adheres adjacent re-passivated strips to one another and electrically connects the re-passivated strips to form a string, and encapsulating the string.

The sorting may include sorting the strips to ensure that similar shaped strips are grouped together. Still further the method may include applying pressure to the stack to limit ingress of passivation materials.

The method may include thermally treating the unpassivated portions of the strips, or oxidizing the unpassivated portions of the strips in an ozone chamber, or chemically bathing the unpassivated portions of the strips, or depositing a passivating material on the unpassivated portions of the strips.

The solar cells may be are square solar cells or pseudo-square solar cells. And the solar cells may include bus bars on at least one side and may further include fingers on at least one side.

### Brief Description of the Drawings

Various aspects of the present disclosure are described hereinbelow with reference to the drawings, which are incorporated in and constitute a part of this specification, wherein:
Fig. 1 is a perspective view of a solar cell with bus bars;
Fig. 2 is a perspective view of a solar cell without bus bars;
Fig. 3 is a front view of the solar cell of Fig. 1;
Fig. 4 is a back view of the solar cell of Fig. 1;
Fig. 5 is a front view of the solar cell of Fig. 2;
Fig. 6 is a back view of the solar cell of Fig. 2;
Fig. 7 is a front view or bottom view of another solar cell according an embodiment of the present disclosure;
Fig. 8 is a front view of a strip formed from the solar cell of Fig. 2;
Fig. 9 is a front view of a strip formed from the solar cell of Fig. 1;
Fig. 10 is a side view depicting shingled strips;
Fig. 11 is a front view of a string according to an embodiment of the present disclosure;
Fig. 12 is a front view of a string according to another embodiment of the present disclosure;
Fig. 13 is a front view of a solar module according to an embodiment of the present disclosure;
Fig. 14 is a schematic showing the layout of the solar module of Fig. 13;
Fig. 15 is a flow chart describing a process of forming the solar module of Fig. 13; and
Fig. 16 is a flow chart describing processes of re-passivation in accordance with the present disclosure.

### Detailed Description

The present disclosure is directed to a method of forming solar modules and particularly solar modules formed using shingling processes employing strips of solar cells that have undergone a re-passivation process.

The solar cells of the present disclosure are used as the building block of solar modules. A solar cell is made up of a substrate configured to be capable of producing energy by converting light energy into electricity. Examples of suitable photovoltaic material include, but are not limited to, those made from multicrystalline or monocrystalline silicon wafers. These wafers may be processed through the major solar cell processing steps, which include wet or dry texturization, junction diffusion, silicate glass layer removal and edge isolation, silicon nitride anti-reflection layer coating, front and back metallization including screen printing, and firing. The wafers may be further processed through advanced solar processing steps, including adding rear passivation coating and selective patterning to thereby obtain a passivated emitter rear contact (PERC) solar cell, which has a higher efficiency than solar cells formed using the standard process flow mentioned above. The solar cell may be a p-type monocrystalline cell or an n-type monocrystalline cell in other embodiments. Similar to the diffused junction solar cells described as above, other high efficiency solar cells, including heterojunction solar cells, can utilize the same metallization patterns in order to be used for the manufacture of a shingled array module. The solar cell may have a substantially square shape with chamfered corners (a pseudo-square) or a full square shape.

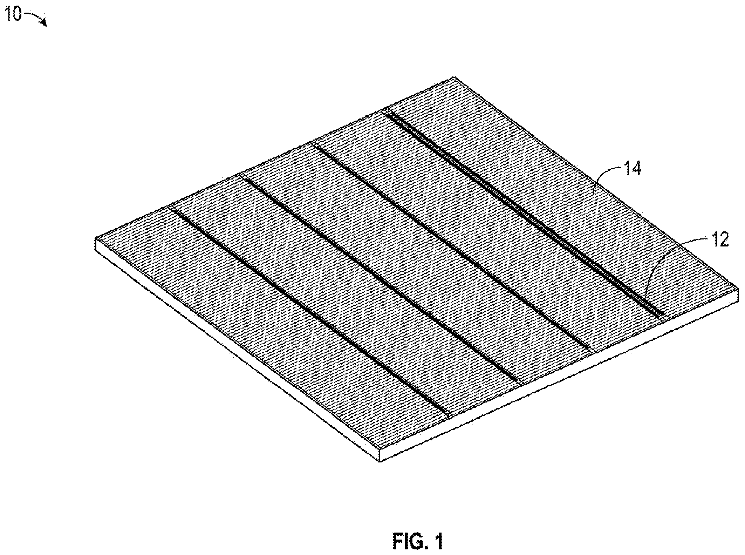

Fig. 1 depicts a front configuration of a first solar cell 10 in accordance with the present disclosure. The solar cell 10 includes five (5) bus bars 12. Finger lines 14 extend across each of the portions of solar cell 10 and terminate at the ends thereof at the bus bars 12 and/or edges of solar cell 10. The finger lines 14 and bus bars 12 together form a metallization pattern of the solar cell 10. Typically the metallization pattern is formed of a conductor such as silver and is printed on the solar cell 10 during manufacturing. Though depicted here with 5 bus bars, and as will be described below these will be singulated into 5 separate strips, the present disclosure is not so limited. The solar cell may have no bus bars, and may be singulated into any number of strips including 2, 3, 4, 5, 6, or more strips.

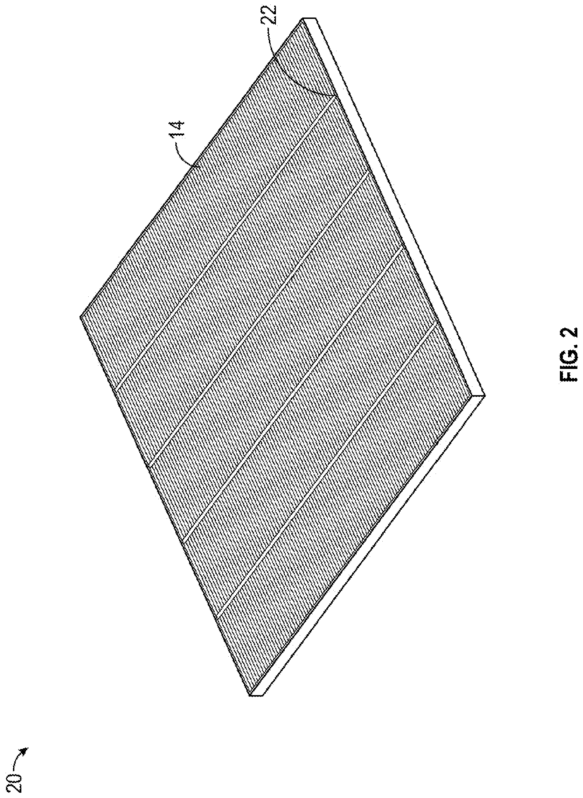

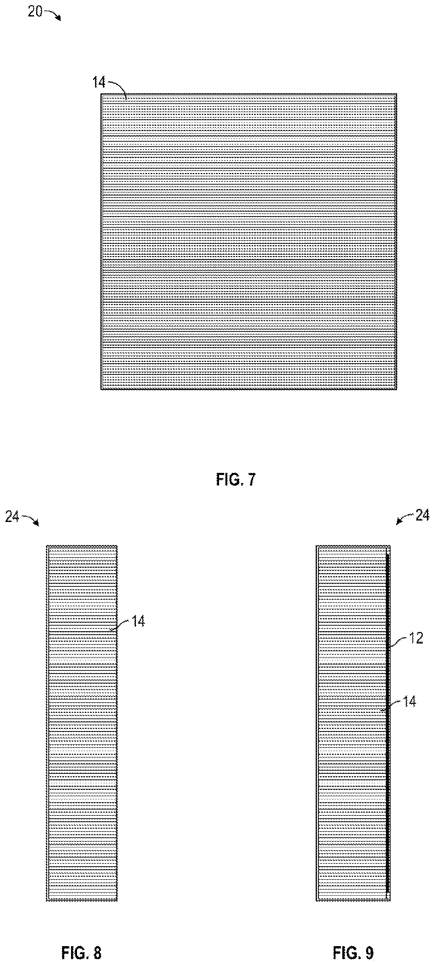

Fig. 2 depicts a front configuration of a second solar cell 20 in accordance with the present disclosure. The solar cell 20 includes finger lines 14, but no bus bars are formed on the solar cell. Cut lines 22 separate the finger lines 14 from extending across the entirety of the solar cell 20. These cut lines 22 are the lines along which the solar cell 20 will be etched (described in greater detail below) and then separated into individual strips 24 (see Figs. 8 and 9). In contrast with Figs. 1 and2 having a square design, those of skill in the art will recognize the solar cells may also be formed in a pseudo-square without departing from the scope of the present disclosure.

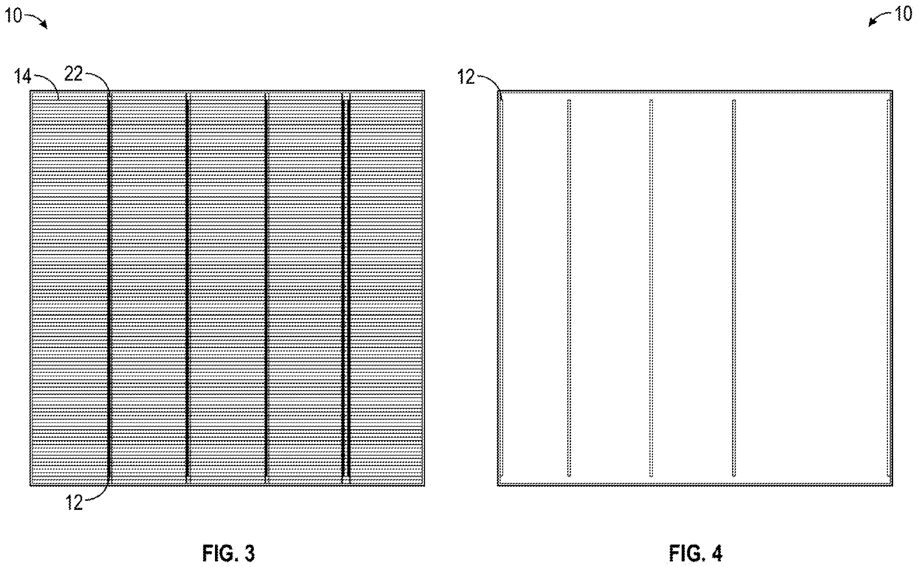

Figs. 3 and 4 depict the front and back sides respectively of solar cell 10 of Fig. 1. In this embodiment, bus bars 12 but no fingers 14 are printed on the back side of the solar cell 10. As such, this configuration has limited, if any, ability to collect solar energy via the back side of the solar cell 10. In an alternative embodiment, fingers 14 may be printed or deposited on the back side of the solar cell 1 0, to produce a design similar to what is depicted in Fig. 3 on the back side of the solar cell 10. In Fig. 3, the fingers 14 are shown extending through the cut line, however, it is also contemplated that the fingers 14 do not extend into the cut line 22.

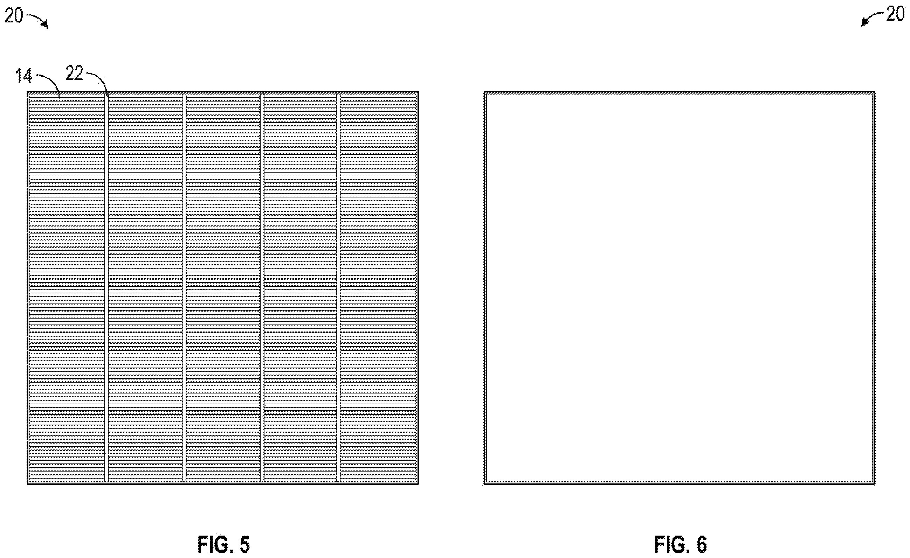

Figs. 5 and 6 depict front and back sides, respectively, of solar cell 20 of Fig. 2. In this embodiment, on the front side shown in Fig. 5, fingers 14 are formed between cut lines 22, to define individual strips 24 without bus bars 12. In Fig. 6, no fingers 14 are formed on the back side of the solar cell 20. In an alternative embodiment, the back side of the solar cell 20 may include fingers 14 and define a design that is identical to the front side depicted in Fig. 5. Additionally or alternatively, the fingers 14 formed on the back side may have a greater density. That is, there may be more fingers 14 on the back side than on the front side. An example of this can be seen in U.S. Design Patent Application No. 29/624485 filed November 1, 2017, entitled SOLAR CELL. In yet a further embodiment, either or both of the front and back sides of the solar cell 20 may have no cut lines, as depicted in Fig. 7, and the fingers 14 may thus extend the entire width of the solar cell 20.

Once the solar cells 10 or 20 are manufactured with the finger 14 patterns either with or without the cut lines 22 as, the cells 10, 20 are ready to be singulated. Singulation is the cutting (often by etching) along the cut line 22. The etching removes material, for example in the cut line 22, to weaken the solar cell 20. Each etching has a depth of between about 10% and about 90% of wafer thickness. The etching may be formed using a laser, a dicing saw, or the like. In an embodiment, the etching extends across the solar cell 10, 20 from edge to edge. In another embodiment, the etching extends from one edge to just short of an opposite edge of the solar cell 1 0, 20. Once weakened, application of a force to the weakened areas results in the breaking of the solar cell 10, 20 along the etching to form strips 24 as depicted in Fig. 3. In the example of the solar cell 10, 20 five individual strips 24 are formed. As will be appreciated 3, 4, 5, 6, or any other suitable number of strips can be formed during singulation depending upon the original construction of the solar cell 1 0, 20. Fig. 8 depicts a single strip 24 after the solar cell 20 has gone through a singulation process. Fig. 9 depicts a single strip 24 after the solar cell 10 (including the bus bars 12) has gone through singulation.

In order to singulate, the solar cell 10, 20 is placed on a vacuum chuck including a plurality of fixtures which are aligned adjacent each other to form a base. The vacuum chuck is selected so that the number of fixtures matches the number of discrete sections of the solar cell 10, 20 to be singulated into strips 24. Each fixture has apertures or slits, which provide openings communicating with a vacuum. The vacuum, when desired, may be applied to provide suction for temporarily mechanically coupling the solar cell 10, 20 to the top of the base. To singulate the solar cell 10, 20, the solar cell 10, 20 is placed on the base such that the each discrete section is positioned on top of a corresponding one of the fixtures. The vacuum is powered on and suction is provided to maintain the solar cell 10, 20 in position on the base. Next, all of the fixtures move relative to each other. In an embodiment, multiple ones of the fixtures move a certain distance away from neighboring fixtures thereby causing the discrete sections of the solar cell 10, 20 to likewise move from each other and form resulting strips 24. In another embodiment, multiple ones of the fixtures are rotated or twisted relative to their longitudinal axes thereby causing the discrete sections of the solar cell 1 0, 20 to likewise move and form resulting strips 24. The rotation or twisting of the fixtures may be effected in a predetermined sequence, in an embodiment, so that no strip 24 is twisted in two directions at once. In still another embodiment, mechanical pressure is applied to the back surface of the solar cell 10, 20 to substantially simultaneously break the solar cell 10, 20 into the strips 24. It will be appreciated that in other embodiments, other processes by which the solar cell 10, 20 is singulated may alternatively be implemented.

After the solar cell 10, 20 is singulated, the strips 24 may optionally be sorted. Though not shown in the figures, a common shape for a solar cell is a so-called pseudo-square, in which the four corners of the cell are chamfered. As a result when singulating pseudo-square cells the two end strips 24 of a pseudo-square solar cell will have a different shape (chamfered corners) than the center three strips 24 (rectangular). Like formed strips 24 are collected and sorted together. In an embodiment, sorting strips 24 is achieved using an auto-optical sorting process. In another embodiment, the strips 24 are sorted according to their position relative to the full solar cell 10, 20. After sorting, strips 24 having chamfered corners are segregated from those strips 24 having rectangular non-chamfered corners. For further processing, in accordance with one aspect of the present disclosure, only like strips 24 are used together (either chamfered or rectangular). Further, depending on which configuration of front and back surfaces (see Figs. 4, 6, 7, etc.) is utilized, the segregation may require ensuring that the strips 24 are properly aligned with one another.

From these singulated strips 24, solar modules may be formed using shingling techniques as described in co-pending U.S. Application Serial No. 15/622,783 entitled SHINGLED ARRAY SOLAR CELLS AND METHOD OF MANUFACTING SOLAR MODULES INCUDING THE SAME.

However, as a result of the singulation process, namely etching and breaking of the solar cell 10, 20 along the cut line, the passivation of the cell 1 0, 20 is disrupted and native silicon surfaces are exposed, particularly on the side walls of the strips 24, these surfaces are un-passivated. Unpassivated surfaces such as the exposed native silicon surfaces of the strip 24 sidewalls are effective recombination centers and if left untreated result in efficiency losses in the strips 24 and a solar module formed of the strips 24. Active recombination centers permit recombination of photon generated electrons and holes reducing the efficiency of solar cells. Passivation is the process of protecting a solar cell's surfaces by depositing or forming a material which reduces or eliminates the recombination center, particularly at the surface of the solar cell, and therewith enhances solar cell and solar module efficiency. This process also protects the solar cell from unnecessary oxidation, contamination, and other perils of harsh environments. Two common techniques for passivation of surfaces are glassivation and oxide passivation.

Typically the solar cell 10, 20 can be passivated using a number of schemes depending on factors such as the thermal, UV, and long-term stability, the optical properties (e.g., parasitic absorption, refractive index), and the processing requirements (e.g., surface cleaning, available fabrication methods). Silicon nitride (a-SiNx:H) is an important material in Si photovoltaics as it is used in virtually all solar cells as an antireflective coating. a-SiNx:H also provides (some) surface passivation and, for multicrystalline Si, it provides bulk passivation by hydrogenation of bulk defects. Traditionally, thermally-grown SiO2 has been used as effective passivation scheme in high efficiency laboratory cells. Thermal-oxidation generally leads to excellent passivation properties irrespective of doping type and surface concentration. Another widely-investigated material is amorphous Si (a-Si:H). The combination of intrinsic and doped a-Si:H nanolayers (< 10 nm) has also been successfully applied in (commercial) hetero-junction solar cells.

However, not all of these methods will be appropriate or cost effective for large scale production of solar modules. In accordance with an example not being part of the present invention, the un-passivated surfaces could be individually re-passivated by exposing the strips 24 to an oxidizing environment. This exposure will result in the oxidation of the surface to eliminate the active recombination centers. This may be done using, for example, a furnace to heat treat the un-passivated surfaces, or an ozone chamber or chemical bath to chemically treat the un-passivated surface. This may be done in batches where the furnace, chamber, or bath is sized to receive several hundred or even thousands of strips 24 for treatment. After re-passivation, the strips 24 can then be assembled as solar modules and not suffer the reduced power output caused by the unpassivated surfaces.

In the present invention, rather than exposing the entire strip 24 to the furnace, chamber, or bath, the strips 24 can be collected and formed into a stack. The top and bottom surfaces of the stack are covered, as are the shorter sides of the strips 24 which have not been affected by the singulation process. This stacking may be done in connection with a jig or receptacle that provides the covering for the front and back and desired sides of the strips 24. After careful collection and alignment of all of the strips 24 pressure may be applied to limit the ability of any treatment material entering between any two strips 24. Once so assembled, the entire stack may be placed in the furnace, chamber, or bath for treatment. In this way, impact to the front and back surfaces of the strips 24, which have not been un-passivated and are of greater importance for the production of energy, are not affected in the re-passivation process.

As a further alternative, once assembled in a stack the strips 24 may be placed in a reaction chamber and a thin passivation layer deposited on the un-passivated surfaces. The passivation layer may be formed of amorphous silicon, silicon oxide, silicon nitride, or others. Again, the front and back surfaces of the strips 24, which are the primary surfaces for power generation, are not affected by this additional treatment step.

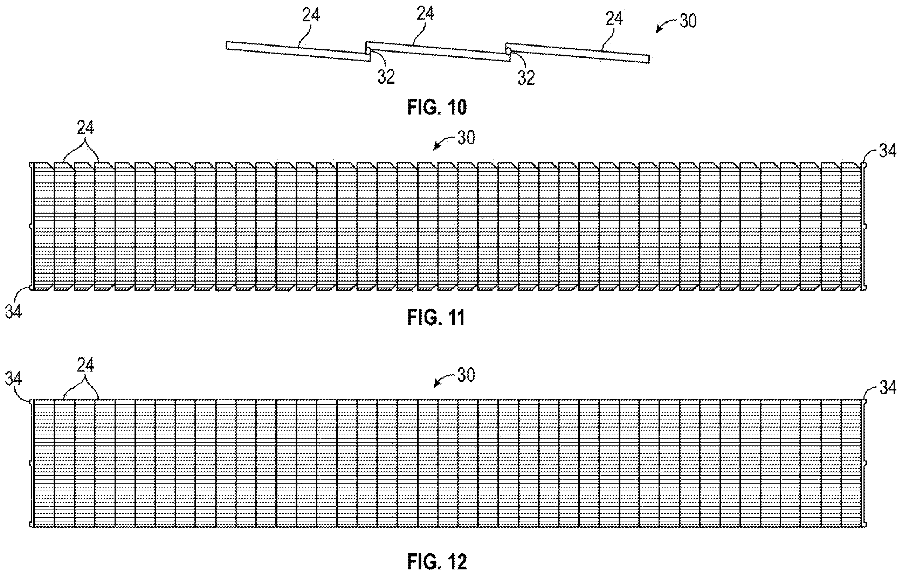

Once sorted and segregated, and re-passivated, the strips 24 are ready to be assembled into strings 30. To form strings 30, as shown in Fig. 10, multiple strips 24 are aligned in an overlapping orientation. An electrically-conductive adhesive 32 is applied to a front surface of a strip 24 along an edge of the strip 24 and a back surface of a neighboring strip is placed into contact with the electrically-conductive adhesive 32 to mechanically and electrically connect the two strips 24. As will be appreciated, the electrically-conductive adhesive 32 may additionally or alternatively be applied to a back surface of a strip 24 and then placed in contact with the front surface of a neighboring strip 24. The electrically-conductive adhesive 32 may be applied as a single continuous line, as a plurality of dots, dash lines, etc., for example, by using a deposition-type machine configured to dispense adhesive material to a surface. In an embodiment, the adhesive 32 is deposited such that it is shorter than the length of the strip 24 and has a width and thickness to render sufficient adhesion and conductivity. The steps of applying the adhesive 32 and aligning and overlapping the strips 24 are repeated until a desired number of strips 24 are adhered to form the string 30. A string 30 may include, for example, 10 to 100 strips.

FIG. 11 depicts a top view of a string 30 formed of multiple strips 24, by the process outlined above with respect to Fig. 10. In Fig. 11, the chamfered corner strips 24 (e.g., made from pseudo-square cells) are adhered together. An end of the string 30 includes a metal foil 34 soldered or electrically connected using electrically-conductive adhesive 32 to the end strip 24. The metal foil 34 will be further connected to a module interconnect bus bar so that two or more strings 30 together form the circuit of a solar module, as will be discussed in detail in subsequent paragraphs below. In another embodiment, the module interconnect bus bar can be directly soldered or electrically connected to the end strip 24 to form the circuit. In another embodiment, as illustrated in FIG. 12, rectangular strips 24 are adhered to each other to form a string 30. Similar to the string 30 shown in FIG. 11, the string 30 includes, for example, 15 to 100 strips 24 where each strip 24 is overlaps an adjacent strip24. The string 30 of FIG. 12 also includes electrical connections for coupling to another similarly configured string 30.

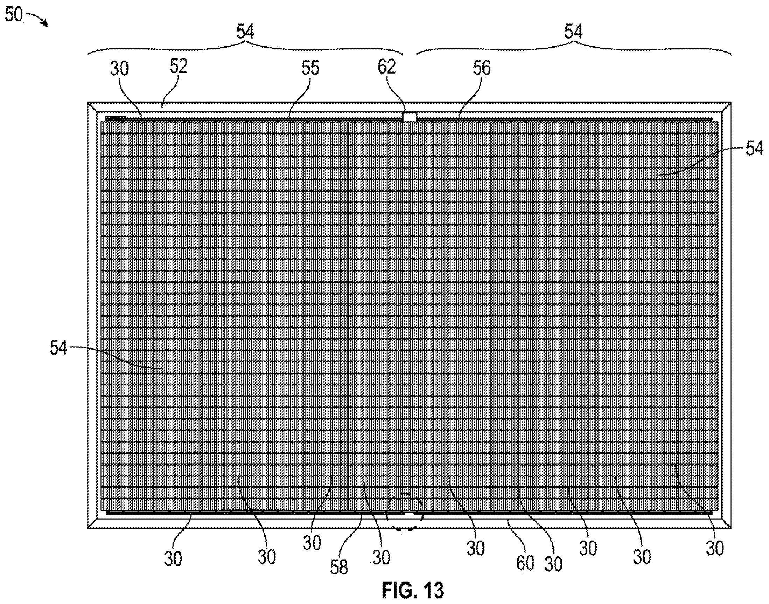

FIG. 13 is a front view of a solar module 50 in accordance with an embodiment of the disclosure. The solar module 50 includes a back sheet (described in greater detail below) and a frame 52 surrounding all four edges of the solar module 50. The frame 52 is formed from anodized aluminum or another lightweight rigid material.

Strings 30 formed of strips 24, ten of which are shown here, are disposed over the back sheet. Although not specifically depicted, it will be appreciated that a glass layer is disposed over the strips 24 and electrical connections associated therewith for protective purposes. Here, the strips 24 are rectangular. The strings 30 are disposed side-by-side lengthwise across the solar module 50.

The edges of any two adjacent strings 30 are spaced apart providing a small gap 54 there between. The gap 54 has a uniform width between the two adjacent strings 30 in a range of between about 1 mm and about 5 mm. In another embodiment, the edges of two or more of the strings 30 are immediately adjacent each other.

The strings 30 are grouped together, for example, in Fig. 13 as a set 54 of five (5) strings 30. These five (5) strings are arranged electrically in parallel. A second set 54 of five (5) strings 30, also connected electrically in parallel, are grouped together and form the second half of the solar module 50. At a top edge of the solar module 50, one set 54 of strings 30 is connected to a bus bar 55 which extends along a portion of length of the solar module 50 and the second set 54 of strings 30 is connected to a second bus bar 54. At a bottom edge of the solar module 50 two bus bars 58 and 60 complete the electrical connections of the sets 54 of strings 30. As a result, as shown in Fig. 10, the strings 30 of each set 54 are connected in parallel with each other and each set 54 is then connected in series with the other. An isolation strip 62 (which may ultimately be hidden from view) is disposed between the two string sets 54 to provide support. The isolation strip 62 is greater in length than the strings 30 and is sufficiently wide to permit the adjacent strings 30 of the two string sets 54, respectively, to overlap a portion of the isolation strip 62.

In accordance with one embodiment, the series connection of the first string set 54 to the second string set 54 can be made by attaching the negative side of the first string set 54 and the positive side of the second string set 54 to a common bus bar. Alternatively, positive sides of both the first and second string sets 54 may be placed on the same side of the solar module and a cable, wire, or other connector may be used to electrically connect the negative side of the first string set 54 to the positive side of the second string set 54. This second configuration promotes efficiency in manufacturing by allowing all string sets 54 to be placed in the solar module 50 without reorientation of one of them, and reduces the size of the bus bars 54, 55, 58, 60, as well as making all bus bars 54, 55, 58, 60 of similar length rather than having one side be long and the other side formed of two short bus bars, thus reducing the number of components of the entire module 50.

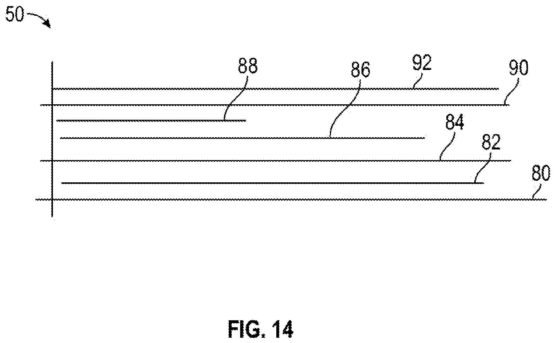

FIG. 14 is a simplified cross-sectional view of a solar module 50 after construction. As shown, solar module 50 has a front sheet layer 80, which serves as a front of the solar module 50, an EVA layer 82, a ribbon layer 84, a set 54 of strings 30 layer 86, an isolation strip layer 88, a rear EVA layer 90, and a back sheet layer 92. The front and back sheet layers 80 and 92 may be formed of glass, transparent polymeric material, or other materials without departing from the scope of the present disclosure.

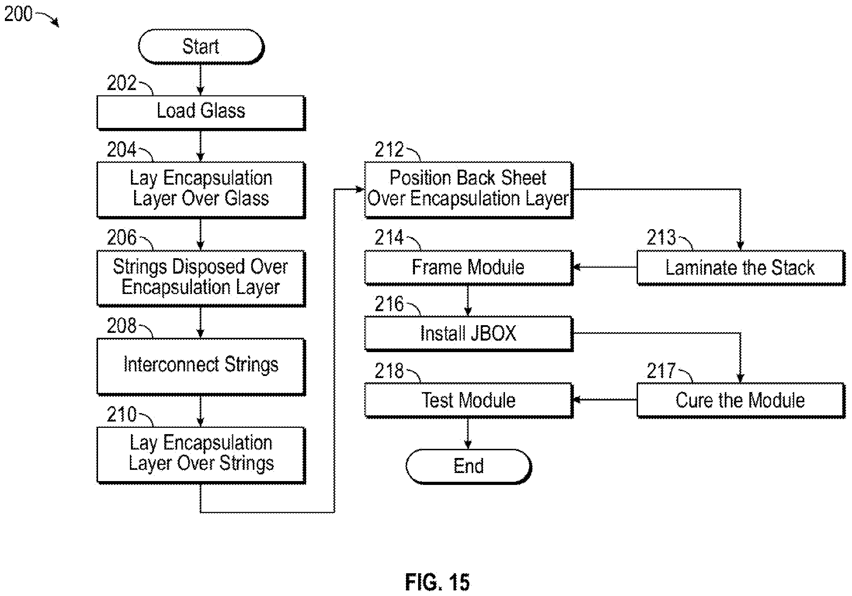

FIG. 15 is a flow diagram of a method 200 of manufacturing a solar module, such as the solar module 50 described above. In an embodiment, a front sheet (e.g. a glass plate), is loaded as the substrate at step 202, and then an encapsulation layer, such as ethylene vinyl acetate (EVA) or poly olefin (POE) film, is laid on top of glass at step 204. Next, string sets 54 are disposed over the encapsulation layer at step 206. In an embodiment, a desired number of string sets 54 can be appropriately positioned and electrically connected by module interconnect bus bars (e.g., bus bars 55, 56, 58, and 60) to form a desired circuitry. For example, the solar module 50 to be manufactured may be made up of 10 sets 54 of strings 30 and hence, may have a length of between about 1600 mm to about 1700 mm, a width of between about 980 mm to about 1100 mm, and a thickness of between about 2 mm to about 60 mm. In another embodiment, the solar module 50 may be made up of 1 to 18 sets 54 of strings 30 and the glass plate can have a length of between about 500 mm to about 2500 mm, a width of between about 900 mm to about 1200 mm, and a thickness of between about 2 mm to about 60 mm.

The sets 54 of strings 30 are positioned over an EVA layer and glass in a configuration as described above with respect to the solar module 50. The sets 54 of strings 30 may be placed one at a time over the EVA layer, in an embodiment. Alternatively, the desired number of sets 54 of strings 30 may be substantially simultaneously placed over the EVA layer. Suitable machinery for automated laying up of the sets 54 of strings 30 commonly used in mass production of solar modules 50 may be employed.

To form connections between the sets 54 of strings 30, the strings 30 are interconnected at step 208. For example, bus bars (e.g., bus bars 55, 56, 58, 60) are electrically connected to corresponding portions of the sets 54 of strings 30 via conductive ribbon material. An isolation strip 62 including suitably positioned electrically conductive ribbons (not shown) adhered thereto, is positioned to extend between two adjacent sets 54 of strings 30 in the manner described above. Electrical wires to be hidden in a junction box (not shown) are either protected or otherwise isolated in order to permit the wires to be placed in the junction box at later stages of manufacture.

Next, another encapsulation layer is laid on top of the sets 54 of strings 30 at step 210. Then, a backsheet is positioned over the encapsulation layer at step 212 to form one or more lamination stacks. The backsheet material protects the solar module circuitry from environmental impact. In an embodiment, the back sheet is dimensioned slightly larger than the glass plate to improve the manufacturing yield. In another embodiment, the backsheet material can be replaced with glass to offer even better protection from environment.

After the back sheet layup, the lamination stacks are loaded into a vacuum lamination chamber in which the stacks are adhered to each other under a high temperature profile in vacuum. The particular details of the lamination process are dependent on the specific properties of the encapsulation material used.

After lamination, the module is framed at step 214. Framing is employed to provide mechanical strength that is sufficient to withstand wind and snow conditions after the solar module 50 is installed. In an embodiment, the framing is made up of anodized aluminum material. In another embodiment, the framing is disposed on an outer edge of the solar module 50. In still another embodiment, the framing extends over a portion of the glass and/or the back sheet. Additionally, silicone is used to seal the gap between glass and framing so that the edges of the solar module 50 are protected from unwanted materials that may unintentionally become trapped within the solar module 50 which can interfere with the operation of the solar module 50. As will be appreciated, solar modules 50 without frames may also be formed without departing from the scope of the present disclosure.

After framing, a junction box is installed on the backsheet, and the interconnect ribbons and bus bars (e.g., bus bars 55, 56, 58, 60) are soldered or clamped to contact pads in the junction box at step 216. Silicone potting material may be used to seal the edge of junction box to prevent moisture and or contaminants getting into the solar module 50. In addition, the junction box itself may be potted to prevent the component from corrosion.

The module is tested at step 218. Examples of tests include, but are not limited to flash testing to measure the module power output, electroluminescence testing for crack and micro-crack detection, grounding testing and high pot testing for safety, and the like.

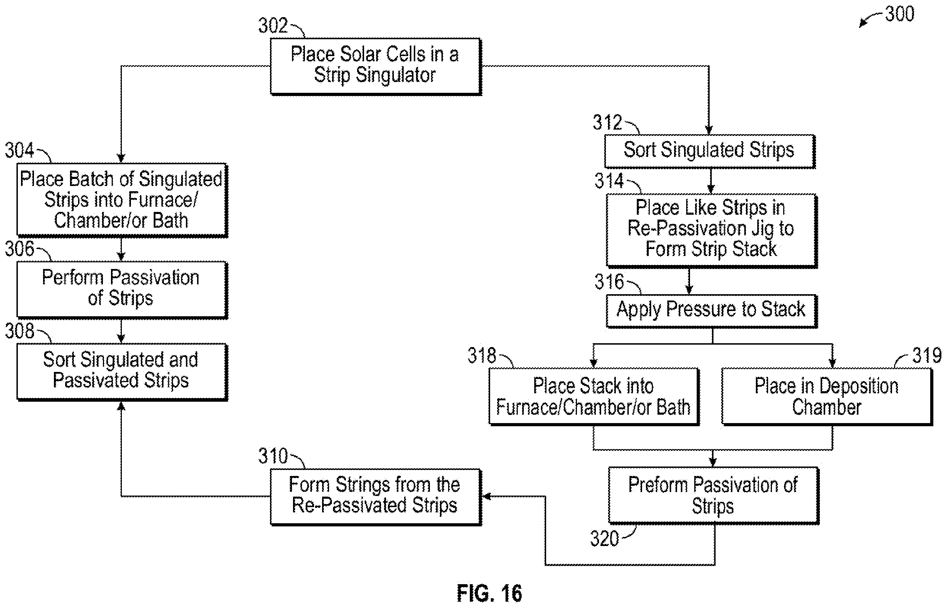

Fig. 16 is a simplified flow diagram for a method 300 of re-passivation of strips 24 in accordance with the present disclosure. With additional reference to Figs. 1, 2, As an initial step the solar cells, e.g., solar cells 10, 20 (Figs. 1 and 2, respectively), must be singulated, which is undertaken at step 302. Next, in an example not being part of the present invention, if re-passivation of the entire strips 24 is warranted, the method proceeds to step 304, where a batch (e.g., 300-500) of strips 24 is placed in a furnace, ozone chamber, or chemical bath. When exposed to heat, ozone, or chemicals, the strips 24 are re-passivated at step 308. Once re-passivated, the strips 24 can be used to form strings 30 and modules 50 at step 310, and as described in connection with Fig. 15.

Where only the cut sides of the strips 24 are to be re-passivated or exposed to the passivation process, the method requires a step 312 of sorting the singulated strips 24 following singulation. Next the strips 24 are placed in a jig at step 314, which may result in covering the top most string 30, the bottom most string 30, and the sides which had not been previously un-passivated. This prevents the passivation processes from significantly impacting those sides and otherwise affecting the surfaces, their passivation, reflective coatings and metallization patterns. Once placed in the jig to form a stack, pressure is applied in step 316 to the stack to further limit the ability of passivation materials from impacting the front and back surfaces (and passivated sides) of the strips 24. With pressure applied, the stack is placed in the furnace, ozone chamber, or chemical bath at step 318 and passivation is performed in step 320. Alternatively the stack may be placed in a deposition chamber where a deposition process may be undertaken. Finally at step 320 the passivation is performed and the strips 24 may then be used to form strings 30 and modules 50 at step 310.

Though the preceding has been described in connection with the formation of strings of shingled strips 24, these same re-passivation techniques can also be undertaken with respect to traditional ribbon interconnected cells. A current trend in ribbon interconnected solar modules is to utilize a half cell, that is the standard 156 mm X 156 mm cell is singulated to form two cells 156 mm X 78 mm. As described above, these singulated half-cells have two exposed edges in need of re-passivation. The techniques described herein can be employed in the manufacture of modules utilizing these half cells. The main difference in this technique is that rather than shingle the half cells after re-passivation, the half cells are aligned and interconnected with ribbons which are typically soldered to the half cell and then its neighboring half cell, in series to form a string of half cells. Multiple half cell strings can then be connected in parallel across module bus bars to form a module following encapsulation and interconnection of the strings, essentially as described above with the shingled cells.

While several embodiments of the disclosure have been shown in the drawings, it is not intended that the disclosure be limited thereto, as it is intended that the disclosure be as broad in scope as the art will allow and that the specification be read likewise. Any combination of the above embodiments is also envisioned and is within the scope of the appended claims. Therefore, the above description should not be construed as limiting, but merely as exemplifications of particular embodiments. Those skilled in the art will envision other modifications within the scope of the claims appended hereto.

## Claims

1. A method comprising:
singulating (302) a solar cell (10; 20; 50) to form a plurality of strips (24), wherein the singulation exposes unpassivated portions of the solar cell (10; 20; 50);
sorting (312) the strips (24) which includes placing the singulated strips (24) in a stack with the unpassivated portions aligned;
covering at least top and bottom surfaces of the stack or covering all passivated surfaces of the strips (24) placed in the stack leaving only the unpassivated portions exposed;
re-passivating (306, 320) the unpassivated portions of the plurality of strips (24) placed in the stack, wherein the re-passivation eliminates active recombination centers;
aligning the re-passivated strips (24) in an overlapping pattern;
depositing electrically conductive adhesive (32), ECA, between the overlapped portions of the re-passivated strips (24), wherein the ECA (32) adheres adjacent re-passivated strips (24) to one another and electrically connects the re-passivated strips (24) to form a string (30); and
encapsulating the string (30).

2. The method of claim 1, wherein sorting (312) the strips (24) further includes grouping similar shaped strips (24) together.

3. The method of claim 1, further comprising applying pressure (316) to the stack to limit ingress of passivation materials.

4. The method of claim 3, further comprising thermally treating the unpassivated portions of the strips (24).

5. The method of claim 3, further comprising oxidizing the unpassivated portions of the strips (24) in an ozone chamber.

6. The method of claim 3, further comprising chemically bathing the unpassivated portions of the strips.

7. The method of claim 3, further comprising depositing a passivating material on the unpassivated portions of the strips (24).

8. The method of claim 1, wherein the solar cells (10; 20; 50) are square solar cells.

9. The method of claim 1, wherein the solar cells (10; 20; 50) are pseudo-square solar cells.

10. The method of claim 1, wherein the solar cells (10; 20; 50) include bus bars (12) on at least one side.

11. The method of claim 1, wherein the solar cells (10; 20; 50) include fingers (14) on at least one side.

## Patentansprüche

1. Verfahren, umfassend:
Vereinzeln (302) einer Solarzelle (10; 20; 50), um eine Vielzahl von Streifen (24) zu bilden, wobei das Vereinzeln unpassivierte Abschnitte der Solarzelle (10; 20; 50) freilegt;
Sortieren (312) der Streifen (24), das ein Anordnen der vereinzelten Streifen (24) in einem Stapel umfasst, wobei die unpassivierten Abschnitten ausgerichtet sind;
Abdecken von mindestens oberen und unteren Oberflächen des Stapels oder Abdecken aller passivierten Oberflächen der in dem Stapel angeordneten Streifen (24), wobei nur die unpassivierten Abschnitte freigelegt sind;
Repassivieren (306, 320) der unpassivierten Abschnitte der Vielzahl von Streifen (24), die in dem Stapel angeordnet sind, wobei das Repassivieren aktive Rekombinationszentren eliminiert;
Ausrichten der repassivierten Streifen (24) in einem überlappenden Muster;
Aufbringen von elektrisch leitfähigem Klebstoff (32), ECA, zwischen den überlappenden Abschnitten der repassivierten Streifen (24), wobei der ECA (32) benachbarte repassivierte Streifen (24) aneinanderklebt und die repassivierten Streifen (24) elektrisch verbindet, um eine Reihe (30) zu bilden; und
Einkapseln der Reihe (30).

2. Verfahren nach Anspruch 1, wobei das Sortieren (312) der Streifen (24) ferner ein Gruppieren ähnlich geformter Streifen (24) miteinander umfasst.

3. Verfahren nach Anspruch 1, ferner umfassend ein Aufbringen von Druck (316) auf den Stapel, um ein Eindringen von Passivierungsmaterialien zu begrenzen.

4. Verfahren nach Anspruch 3, ferner umfassend ein thermisches Behandeln der unpassivierten Abschnitte der Streifen (24).

5. Verfahren nach Anspruch 3, ferner umfassend ein Oxidieren der unpassivierten Abschnitte der Streifen (24) in einer Ozonkammer.

6. Verfahren nach Anspruch 3, ferner umfassend ein chemisches Baden der unpassivierten Abschnitte der Streifen.

7. Verfahren nach Anspruch 3, ferner umfassend ein Abscheiden eines Passivierungsmaterials auf den unpassivierten Abschnitten der Streifen (24).

8. Verfahren nach Anspruch 1, wobei die Solarzellen (10; 20; 50) quadratische Solarzellen sind.

9. Verfahren nach Anspruch 1, wobei die Solarzellen (10; 20; 50) pseudo-quadratische Solarzellen sind.

10. Verfahren nach Anspruch 1, wobei die Solarzellen (10; 20; 50) Sammelschienen (14) auf mindestens einer Seite umfassen.

11. Verfahren nach Anspruch 1, wobei die Solarzellen (10; 20; 50) Finger (14) auf mindestens einer Seite umfassen.

## Revendications

1. Procédé comprenant :
la séparation (302) d'une cellule solaire (10 ; 20 ; 50) pour former une pluralité de bandes (24), dans lequel la séparation expose des parties non passivées de la cellule solaire (10 ; 20 ; 50) ;
le tri (312) des bandes (24) qui comporte le placement des bandes séparées (24) dans un empilement avec les parties non passivées alignées ;
la couverture d'au moins les surfaces supérieure et inférieure de l'empilement ou la couverture de toutes les surfaces passivées des bandes (24) placées dans l'empilement en laissant uniquement les parties non passivées exposées ;
la repassivation (306, 320) des parties non passivées de la pluralité de bandes (24) placées dans l'empilement, dans lequel la repassivation élimine les centres de recombinaison actifs ;
l'alignement des bandes repassivées (24) selon un motif de chevauchement ;
le dépôt d'un adhésif électroconducteur (32), ECA, entre les parties chevauchées des bandes repassivées (24), dans lequel l'ECA (32) fait adhérer des bandes repassivées adjacentes (24) les unes aux autres et connecte électriquement les bandes repassivées (24) pour former une chaîne (30) ;
et l'encapsulation de la chaîne (30).

2. Procédé selon la revendication 1, dans lequel le tri (312) des bandes (24) comprend en outre le regroupement des bandes (24) façonnées similaires.

3. Procédé selon la revendication 1, comprenant en outre l'application d'une pression (316) à l'empilement pour limiter l'entrée de matériaux de passivation.

4. Procédé selon la revendication 3, comprenant en outre le traitement thermique des parties non passivées des bandes (24).

5. Procédé selon la revendication 3, comprenant en outre l'oxydation des parties non passivées des bandes (24) dans une chambre à ozone.

6. Procédé selon la revendication 3, comprenant en outre le bain chimique des parties non passivées des bandes.

7. Procédé selon la revendication 3, comprenant en outre le dépôt d'un matériau de passivation sur les parties non passivées des bandes (24).

8. Procédé selon la revendication 1, dans lequel les cellules solaires (10 ; 20 ; 50) sont des cellules solaires carrées.

9. Procédé selon la revendication 1, dans lequel les cellules solaires (10 ; 20 ; 50) sont des cellules solaires pseudo-carrées.

10. Procédé selon la revendication 1, dans lequel les cellules solaires (10 ; 20 ; 50) comprennent des barres omnibus (12) sur au moins un côté.

11. Procédé selon la revendication 1, dans lequel les cellules solaires (10 ; 20 ; 50) comprennent des doigts (14) sur au moins un côté.
